# EUROPEAN PATENT APPLICATION

(11) **EP 3 059 621 A1**
(43) Date of publication of application: **24.08.2016**
(21) Application number: 14868315.4
(22) Date of filing: 26.11.2014
(51) Int. Cl.: G02B 6/12, C08G 59/14, C08L 63/00, H05K 1/02

(54) **LIGHT-GUIDE PATH AND OPTICAL/ELECTRIC HYBRID BOARD**

(30) Priority: 04.12.2013 JP 2013251255
(71) Applicant: Nitto Denko Corporation, Ibaraki-shi, Osaka 567-8680 (JP)
(72) Inventor: TANAKA Naoyuki, Ibaraki-shi Osaka 567-8680 (JP)
(74) Representative: Hoffmann Eitle
(86) International application number: PCT/JP2014/081144
(87) International publication number: WO 2015/083584

(57) **Abstract**

An optical waveguide is provided, which includes a core layer and a cladding layer, wherein at least one of the core layer and the cladding layer is formed from a transparent resin composition containing a phosphorus-containing epoxy resin and a photopolymerization initiator. The optical waveguide and an opto-electric hybrid board including the optical waveguide are excellent in flame resistance, and permit thickness reduction thereof.

## Description

### TECHNICAL FIELD

The embodiment of the present invention relates to an optical waveguide and an opto-electric hybrid board which are widely used for optical communications, optical information processing and other general optics.

### BACKGROUND ART

Optical waveguides are incorporated in optical waveguide devices, optical integrated circuits and optical wiring boards, and widely used for optical communications, optical information processing and other general optics. With recent trend toward higher capacity and higher speed information transmission, opto-electric hybrid boards are notably developed. An exemplary opto-electric hybrid board includes a variety of optical waveguides provided on an electric wiring board.

Conventionally, quartz-based optical waveguides are typically used, but instead resin-based optical waveguides now attract attention from the viewpoint of production efficiency.

However, conventional resin materials such as epoxy resins and acryl resins for use in the optical waveguides are problematic in terms of flame resistance, because modules employing the optical waveguides and the opto-electric hybrid boards are liable to generate heat. To cope with this, it is a conventional practice to cover an optical waveguide film with a flame resistant film (see PTL 1).

### RELATED ART DOCUMENT

### PATENT DOCUMENT

PTL 1: JP-A-2008-203687

### SUMMARY OF INVENTION

However, the coverage of the optical waveguide film with the flame resistant film leads to higher production costs, and increases the thickness of the overall optical waveguide film to impair the folding resistance of the optical waveguide film as described in PTL 1.

In view of the foregoing, it is an object of the invention to provide an optical waveguide and an opto-electric hybrid board which are excellent in flame resistance and permit thickness reduction thereof.

According to a first aspect of the embodiment of the present invention to achieve the above object, there is provided an optical waveguide including a core layer and a cladding layer, wherein at least one of the core layer and the cladding layer is formed from a transparent resin composition containing a phosphorus-containing epoxy resin and a photopolymerization initiator.

According to a second aspect of the embodiment of the present invention, there is provided an opto-electric hybrid board including the optical waveguide of the first aspect.

The inventor of the embodiment of the present invention conducted intensive studies to solve the aforementioned problems. As a result, the inventor found that, where at least one of the core layer and the cladding layer of the optical waveguide is formed from the transparent resin composition containing the phosphorus-containing epoxy resin and the photopolymerization initiator, it is possible to provide a desired flame resistance imparting effect without the need for covering the optical waveguide with a flame resistant film as in the conventional art, thereby achieving the above object. Thus, the embodiment of the present invention is attained.

The optical waveguide and the opto-electric hybrid board according to the embodiment of the present invention are excellent in flame resistance, because at least one of the core layer and the cladding layer of the optical waveguide is formed from the transparent resin composition containing the phosphorus-containing epoxy resin and the photopolymerization initiator. Without the need for the provision of the flame resistant film, the thickness of the optical waveguide can be reduced. The thickness reduction makes it possible to reduce the weight of the optical waveguide and to improve the folding resistance of the optical waveguide.

### DESCRIPTION OF EMBODIMENTS

Next, an embodiment of the present invention will be described in detail. However, it should be understood that the embodiment of the present invention be not limited to this embodiment.

An optical waveguide according to the embodiment of the present invention includes, for example, a substrate, an under-cladding layer provided in a predetermined pattern on the substrate, a core layer provided in a predetermined pattern on the under-cladding layer for transmitting an optical signal, and an over-cladding layer provided over the core layer. The under-cladding layer and the over-cladding layer are herein collectively referred to as "cladding layer." In the inventive optical waveguide, at least one of the core layer and the cladding layer is formed from a transparent resin composition containing a phosphorus-containing epoxy resin and a photopolymerization initiator. Particularly, the transparent resin composition is preferably used as a material for both the under-cladding layer and the over-cladding layer. The inventive optical waveguide is imparted with a desired flame resistance even without provision of a flame resistant cover layer. Without the provision of the flame resistant cover layer, it is possible to reduce the thickness of the optical waveguide. In the inventive optical waveguide, the cladding layer is required to have a smaller refractive index than the core layer.

An epoxy resin having a phenyl phosphate skeleton represented by the following general formula (1) is preferably used as the phosphorus-containing epoxy resin to be contained in the transparent resin composition: 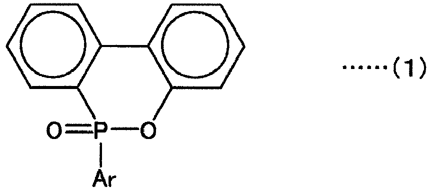 wherein Ar is an aromatic group.

Specific examples of the phosphorus-containing epoxy resin include phosphorus-containing epoxy resins containing an epoxy resin component including a novolak epoxy resin in a proportion of not less than 20 wt%, wherein the phenyl phosphate skeleton represented by the above general formula (1) preferably has a phosphorus content of 1 to 5 wt%. That is, where the phosphorus content falls within the aforementioned range, the phosphorus-containing epoxy resin has a sufficient solubility, and ensures sufficient flame resistance.

Production methods for such a phosphorus-containing epoxy resin are disclosed, for example, in Japanese Patent Nos. 3613724 and 3533973.

The epoxy resin component is not limited to the aforementioned novolak epoxy resin, as long as the epoxy resin is curable. Other examples of the epoxy resin component include bisphenol epoxy resins, biphenyl epoxy resins, fluorene epoxy resins, resorcinol epoxy resins, polyglycol epoxy resins, which may be used alone or in combination.

The proportion of the phosphorus-containing epoxy resin is preferably set in the range of 1 to 80 wt%, more preferably 10 to 25 wt%, based on the weight of the overall transparent resin composition. If the proportion of the phosphorus-containing epoxy resin is less than the aforementioned range, the optical waveguide tends to have insufficient soldering resistance. If the proportion of the phosphorus-containing epoxy resin is greater than the aforementioned range, the transparent resin composition tends to have poorer alkali developability.

Examples of the photopolymerization initiator to be used together with the phosphorus-containing epoxy resin include substituted or unsubstituted polynuclear quinones (2-ethylanthraquinone, 2-t-butylanthraquinone, octamethylanthraquinone, 1,2-benzanthraquinone, 2,3-diphenylanthraquinone and the like), α-ketaldonyl alcohols (benzoin, pivalone and the like), ethers, α-hydrocarbon-substituted aromatic acyloins (α-phenylbenzoin, α,α-diethoxyacetophenone and the like), aromatic ketones (benzophenone and 4,4'-bisdialkylaminobenzophenones such as N,N'-tetraethyl-4,4'-diaminobenzophenone, and the like), thioxanthones (2-methylthioxanthone, 2,4-diethylthioxanthone, 2-chlorothioxanthone, 2-isopropylthioxanthone, 2-ethylthioxanthone and the like), and 2-methyl-1-[4-(methylthio)phenyl]-morpholinopropan-1-one, which may be used alone or in combination.

The proportion of the photopolymerization initiator is preferably set in the range of 0.1 to 10 wt%, more preferably 2 to 8 wt%, based on the weight of the overall transparent resin composition. If the proportion of the photopolymerization initiator is less than the aforementioned range, the transparent resin composition tends to have insufficient curability. If the proportion of the photopolymerization initiator is greater than the aforementioned range, the transparent resin composition tends to have poorer physical properties.

Here, the transparent resin composition may contain a cyclic phosphazene compound, a carboxyl group-containing linear polymer, an ethylenically unsaturated group-containing polymerizable compound and the like as required in addition to the phosphorus-containing epoxy resin and the photopolymerization initiator.

A usable example of the cyclic phosphazene compound is a compound having a structure represented by the following general formula (2): 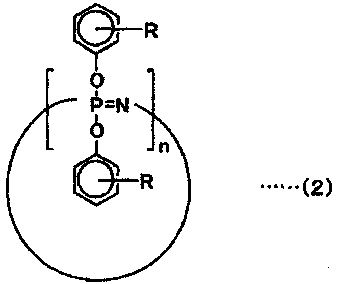 wherein Rs are each a hydrogen atom, a hydroxyl group or an organic group having a urethane (meth)acrylate structure represented by the following general formula (3), at least one of the Rs being the organic group having the urethane (meth)acrylate structure, and n is a positive number of 2 to 5, representing an average polymerization degree: 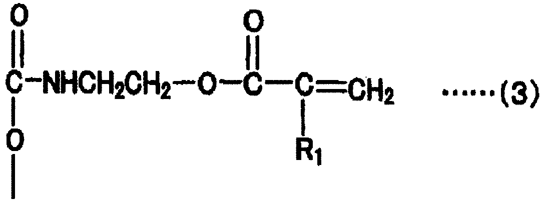 wherein R₁ is a hydrogen atom or a methyl group.

It is particularly preferred that the Rs in the above general formula (2) are both organic groups each having the urethane (meth)acrylate structure represented by the above general formula (3).

The specific cyclic phosphazene compound may be prepared, for example, in the following manner. Hydroquinone is added to a cyclic phenoxyphosphazene compound and heated to be dissolved in the cyclic phenoxyphosphazene compound. Then, (meth)acryloyloxyethyl isocyanate and, as required, a catalyst are added to the resulting mixture, and a reaction is allowed to proceed. Thus, the cyclic phosphazene compound is prepared.

The proportion of the cyclic phosphazene compound is preferably set in the range of 5 to 30 wt%, more preferably 10 to 20 wt%, based on the weight of the overall transparent resin composition. The addition of the cyclic phosphazene compound in the aforementioned proportion imparts the optical waveguide with more excellent flame resistance.

The carboxyl group-containing linear polymer is prepared, for example, by copolymerizing (meth)acrylic acid with other carboxyl group-containing monomer. Since the monomer for the carboxyl group-containing linear polymer can be selected from various types of material monomers, the glass transition temperature (Tg) and other physical properties of the carboxyl group-containing linear polymer can be easily designed.

Examples of the other carboxyl group-containing monomer include alkyl (meth)acrylates such as methyl (meth)acrylate, ethyl (meth)acrylate and butyl (meth)acrylate, 2-ethylhexyl (meth)acrylate, tetrahydrofurfuryl (meth)acrylate, dimethylaminoethyl (meth)acrylate, diethylaminoethyl (meth)acrylate, styrene, α-styrene, vinyltoluene, N-vinylpyrrolidone, 2-hydroxyethyl (meth)acrylate, acrylamide, acrylonitrile, methacrylonitrile, N-phenylmaleimide and cyclohexylmaleimide, which may be used alone or in combination.

The carboxyl group-containing linear polymer preferably has a weight average molecular weight of 3000 to 50000, more preferably 4000 to 40000, further more preferably 5000 to 30000. If the weight average molecular weight is less than the aforementioned range, the soldering resistance tends to be impaired. If the weight average molecular weight is greater than the aforementioned range, the alkali developability tends to be impaired. The weight average molecular weight is determined, for example, by gel permeation chromatography (GPC) based on polystyrene calibration standards.

The carboxyl group-containing linear polymer preferably has an acid equivalent of 200 to 900, more preferably 250 to 850, further more preferably 300 to 800. An acid equivalent less than the aforementioned range is not preferred because oxidation of copper is promoted under high temperature and high humidity conditions. If the acid equivalent is greater than the aforementioned range, the alkali developability tends to be impaired.

More specifically, it is preferred that the carboxyl group-containing linear polymer has structural units represented by the following general formula (4):

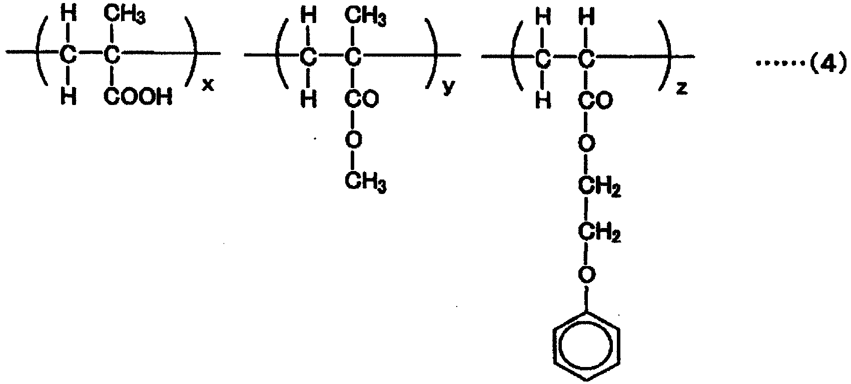

In the above general formula (4), x, y and z are weight ratios of respective monomers for random copolymerization, x being 0.1 to 0.3, y being 0 to 0.9, z being 0 to 0.6.

The carboxyl group-containing linear polymer having the structural units represented by the general formula (4) is prepared, for example, by copolymerizing monomers respectively having the structural units represented by the general formula (4) in their major skeletal structures, (meth)acrylic acid and the aforementioned other carboxyl group-containing monomer.

The proportion of the carboxyl group-containing linear polymer is preferably set in the range of 20 to 60 wt%, more preferably 30 to 50 wt%, based on the weight of the overall transparent resin composition. Where the proportion of the carboxyl group-containing linear polymer falls within the aforementioned range, the transparent resin composition is excellent in developability.

The copolymerization amount of (meth)acrylic acid as the comonomer is preferably set in the range of 10 to 30 wt%, more preferably 15 to 25 wt%, based on the total amount of the comonomers. If the copolymerization amount of (meth)acrylic acid is less than the lower limit of the range, the working efficiency tends to be reduced with a prolonged development period. If the copolymerization amount of (meth)acrylic acid is greater than the aforementioned range, the oxidation of copper tends to be promoted under the high temperature and high humidity conditions.

A bisphenol-A di(meth)acrylate compound represented by the following general formula (5), for example, is preferably used as the ethylenically unsaturated group-containing polymerizable compound for excellent soldering resistance, folding resistance and alkali developability: 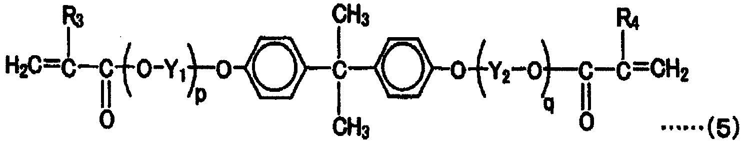 wherein R₃ and R₄, which may be the same or different, are each a hydrogen atom or a methyl group; Y₁ and Y₂ are each a C₂ to C₆ alkylene group; and p and q are positive integers which satisfy a relationship of p + q = 4 to 40.

Examples of the C₂ to C₆ alkylene group in the above general formula (5) include an ethylene group, a propylene group, an isopropylene group, a butylene group, an isobutylene group, a pentylene group, a neopentylene group and a hexylene group, among which the ethylene group is particularly preferred

The isopropylene group is represented by -CH(CH₃)CH₂-. Two possible bonding orientations of the isopropylene group in the -(o-Y₁)- group and the -(Y₂-O)-group in the above general formula (5) are such that the methylene group is bonded to oxygen and such that the methylene group is not bonded to oxygen. In the formula (5), these two bonding orientations may be present alone or in combination.

Where two or more -(O-Y₁)- repeating units and two or more - (Y₂-O)- repeating units are present in the general formula (5), two or more Y₁ groups and two or more Y₂ groups may be the same or different from each other. Where two or more types of alkylene groups are present as Y₁ and Y₂, two or more types of -(O-Y₁)-repeating units and two or more types of -(Y₂-O)-repeating units may be present at random or in a block form.

In the general formula (5), two benzene rings may be each substituted with one or more substituents at substitutable sites thereof. Where the benzene rings each have two or more substituents, the substituents may be the same or different from each other. Examples of the substituents include C₁ to C₂₀ alkyl groups, C₃ to C₁₀ cycloalkyl groups, C₆ to C₁₄ aryl groups, an amino group, a nitro group, a cyano group, a mercapto group, an allyl group, C₁ to C₁₀ alkylmercapto groups, C₁ to C₂₀ hydroxyalkyl groups, carboxyalkyl groups having C₁ to C₁₀ alkyl groups, acyl groups having C₁ to C₁₀ alkyl groups, and C₁ to C₂₀ alkoxy groups and heterocyclic groups.

In the general formula (5), the repeating numbers p and q are positive integers, which satisfy a relationship of p + q = 4 to 40, more preferably p + q = 4 to 15, particularly preferably p + q = 5 to 13. If p + q is less than the aforementioned range, the folding resistance tends to be impaired. If p + q is greater than the aforementioned range, the transparent resin composition tends to be entirely more hydrophilic, resulting in poorer insulation reliability under the high temperature and high humidity conditions.

Specific examples of the bisphenol-A di(meth)acrylate compound represented by the general formula (5) include 2,2'-bis[4-(meth)acryloxydiethoxyphenyl]propane, 2,2'-bis[4-(meth)acryloxytetraethoxyphenyl]propane, 2,2'-bis[4-(meth)acryloxypentaethoxyphenyl]propane, 2,2'-bis[4-(meth)acryloxydiethoxyoctapropoxyphenyl]propane, and 2,2'-bis[4-(meth)acryloxytriethoxyoctapropoxyphenyl]propane, which may be used alone or in combination.

The proportion of the ethylenically unsaturated group-containing polymerizable compound is preferably set in the range of 5 to 50 wt%, more preferably 10 to 40 wt%, based on the weight of the overall transparent resin composition. If the proportion of the ethylenically unsaturated group-containing polymerizable compound is less than the lower limit of the aforementioned range, the transparent resin composition tends to have insufficient sensitivity. If the proportion of the ethylenically unsaturated group-containing polymerizable compound is greater than the aforementioned range, the alkali developability tends to be impaired.

As required, fillers such as silica, barium sulfate and talc, defoaming agents, leveling agents, flame retarders, stabilizing agents, tackifiers, anti-rust agents such as benzotriazole, thermal crosslinking agents such as epoxy resins and block isocyanates, and other additives may be blended in the transparent resin composition for the inventive optical waveguide. These additives may be used alone or in combination. The total amount of these additives to be used is preferably in the range of 0.01 to 20 wt% based on the weight of the overall transparent resin composition.

The transparent resin composition is prepared by blending and mixing the aforementioned ingredients in the aforementioned proportions. As required, the transparent resin composition may be mixed with an organic solvent for use as a transparent resin composition liquid. Examples of the organic solvent include diethylene glycol monoethyl ether acetate, diethylene glycol monobutyl ether acetate, diethylene glycol monoethyl ether, diethylene glycol monomethyl ether, trimethylol propane triacrylate, solvent naphtha, N-methylpyrrolidone, γ-butyrolactone, butyl CELLOSOLVE, ethyl CELLOSOLVE, methyl CELLOSOLVE, toluene, xylene, mesitylene, acetone, methyl ethyl ketone, methyl isobutyl ketone, and solvent mixtures of any of these solvents.

The amount of the organic solvent to be used is preferably about 0 to about 200 parts by weight based on 100 parts by weight of the transparent resin composition.

Here, the (cured) cladding layer formed by using the transparent resin composition preferably has a refractive index of not greater than 1.56, particularly preferably not greater than 1.55. The refractive index of the (cured) cladding layer is measured, for example, in the following manner. A (cured) cladding layer having a thickness of about 10 µm is formed on a smooth surface of a silicon wafer, and the refractive index of the cured cladding layer is measured at 850 nm by means of a prism coupler (SPA-4000) available from SAIRON TECHNOLOGY, Inc.

In the embodiment of the present invention, the optical waveguide is produced, for example, through the following process steps. A substrate is prepared, and a photosensitive varnish of the transparent resin composition is applied onto the substrate. A photomask having a predetermined pattern (optical waveguide pattern) for light exposure is put on the resulting varnish film. Then, the varnish film is irradiated with light such as ultraviolet radiation via the photomask and, as required, heat-treated to be thereby cured. Thereafter, an unexposed portion of the varnish film not irradiated with the light is dissolved away with the use of a developing liquid, whereby an under-cladding layer (lower cladding layer portion) is formed as having the predetermined pattern.

Then, a core formation material (varnish) is applied over the under-cladding layer to form an (uncured) core formation layer. In turn, a photomask having a predetermined pattern (optical waveguide pattern) for light exposure is put on the core formation layer. Then, the core formation layer is irradiated with light such as ultraviolet radiation via the photomask and, as required, heat-treated. Thereafter, an unexposed portion of the core formation layer is dissolved away with the use of a developing liquid, whereby a core layer is formed as having the predetermined pattern.

Subsequently, an over-cladding formation material is applied over the core layer. Then, the resulting over-cladding formation material layer is irradiated with light such as ultraviolet radiation and, as required, heat-treated, whereby an over-cladding layer (upper cladding layer portion) is formed. Thus, the intended optical waveguide is produced through these process steps.

Exemplary materials for the substrate include a silicon wafer, a metal substrate, a polymer film and a glass substrate. Examples of the metal substrate include stainless steel plates such as of JIS SUS. Specific examples of the polymer film include polyethylene terephthalate (PET) films, polyethylene naphthalate films and polyimide films. The substrate typically has a thickness of 3 µm to 3 mm.

Specifically, the light irradiation may be irradiation with ultraviolet radiation. Exemplary light sources for the irradiation with the ultraviolet radiation include a low pressure mercury lamp, a high pressure mercury lamp and an ultrahigh pressure mercury lamp. The dose of the ultraviolet radiation is typically about 10 to about 20000 mJ/cm², preferably about 100 to about 15000 mJ/cm², more preferably about 500 to about 10000 mJ/cm².

After the light exposure by the irradiation with the ultraviolet radiation, the heat treatment may be further performed to complete a photoreaction for the curing. Conditions for the heat treatment are typically a temperature of 80°C to 250°C and a period of 10 seconds to 2 hours, preferably a temperature of 100°C to 150°C and a period of 5 minutes to 1 hour.

Where the transparent resin composition is used as the cladding formation material, an exemplary core formation material may be a resin composition containing a solid polyfunctional aromatic epoxy resin or a solid (viscous) fluorene-containing bifunctional epoxy resin, and any of the aforementioned photopolymerization initiators. For the preparation of the core formation material to be applied in a varnish form, any of conventionally known various organic solvents is used in a proper amount so as to impart the varnish with a viscosity suitable for the application of the varnish.

Examples of the organic solvent include ethyl lactate, methyl ethyl ketone, cyclohexanone, 2-butanone, N,N-dimethylacetamide, diglyme, ethylene diglycol acetate, diethylene glycol methyl ethyl ether, propylene glycol methyl acetate, propylene glycol monomethyl ether, tetramethylfurane and dimethoxyethane. These organic solvents may be used alone or in combination in a proper amount so as to impart the varnish with a viscosity suitable for the application of the varnish.

Exemplary methods for the application of the formation materials for the respective layers on the substrate include coating methods employing a spin coater, a coater, a round coater, a bar coater or the like, a screen printing method, a capillary injection method in which the material is injected into a gap formed with the use of spacers by the capillary phenomenon, and a continuous roll-to-roll coating method employing a coating machine such as a multi-coater. The optical waveguide may be provided in the form of a film optical waveguide by removing the substrate.

On the other hand, an opto-electric hybrid board according to the embodiment of the present invention includes the optical waveguide produced in the aforementioned manner, and may be produced, for example, by forming the under-cladding layer, the core layer and the over-cladding layer on a back surface of a substrate having a copper print electric wiring formed on a front surface thereof.

The opto-electric hybrid board may be constructed in the following manner. After the under-cladding layer is formed on one surface of the substrate in the aforementioned manner, the core layer and a copper print electric wiring are formed on the under-cladding layer, and then the over-cladding layer is formed over the core layer and the electric wiring in the aforementioned manner. Thus, the opto-electric hybrid board is produced as having a construction different from that described above.

### EXAMPLES

Next, inventive examples will be described in conjunction with comparative examples. However, the embodiment of the present invention is not limited to these examples.

Prior to the description of the inventive examples and the comparative examples, prepared ingredients will be described as follows:

### [Phosphorus-Containing Epoxy Resin]

FX-305 available from Tohto Kasei Co., Ltd. and having a phosphorus content of 3 wt%

### [Aliphatic Modified Epoxy Resin]

EPICLONEXA-4816 available from DIC Corporation

### [Aliphatic Epoxy Resin]

EHPE-3150 available from DIC Corporation

### [Cyclic Phosphazene Compound]

A cyclic phosphazene compound (SPB-100 available from Otsuka Chemical Co., Ltd.) represented by the following structural formula (6): 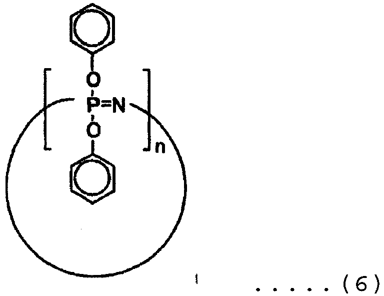 wherein n is 2 to 5 (an average polymerization degree).

### [Carboxyl Group-Containing Linear Polymer]

A polymer prepared by the following synthesis method and having structural units represented by the above general formula (4) (wherein the weight ratio of the repeating units x, y, z was x:y:z = 20:31:49) and a weight average molecular weight (Mw) of 2.3 × 10⁴ as measured by GPC (based on polystyrene calibration standards).

### <Synthesis Method>

First, 135.1 g of ethylene diglycol acetate was poured as a solvent into a 500-ml separable flask in a nitrogen atmosphere, and heated up to 100°C with stirring. After the solvent was kept at 100°C for one hour, a solution obtained by mixing 144.9 g of phenoxyethyl acrylate, 58.0 g of methacrylic acid and 86.9 g of methyl methacrylate (monomers) with 70.4 g of ethylene diglycol acetate (solvent) and 4.6 g of azobisisobutylonitrile (catalyst) was added dropwise into the separable flask in three hours, and a reaction was allowed to proceed. After the resulting solution was stirred at 100°C for two hours, the solution was cooled, and a solid component (polymer) was obtained from the solution.

### [Ethylenically Unsaturated Group-Containing Polymerizable Compound]

A bisphenol-A methacrylate modified with ethylene oxide (BIS-A acrylate BPE500 available from Shin-Nakamura Chemical Co. , Ltd. and represented by the above formula (5) in which p + q = 10)

### [Polyfunctional Ethylenically Unsaturated Group-Containing Polymerizable Compound]

Trimethylolpropane triacrylate

### [Photopolymerization Initiator (a)]

IRGACURE 907 available from Ciba Geigy Corporation

### [Photopolymerization Initiator (b)]

KAYACURE DETX-S available from Nippon Kayaku Co., Ltd.

### [Photopolymerization Initiator (c)]

SP170 available from Adeka Corporation

### [Examples 1 to 3 and Comparative Examples 1 and 2]

### <Preparation of Cladding Formation Varnishes>

Under shaded conditions, the ingredients described above were blended in proportions shown below in Tables 1 and 2 and mixed together. Thus, cladding formation varnishes for the inventive examples and the comparative examples were prepared.

In turn, a core formation varnish was prepared in the following manner, and FPC-combined optical waveguides were produced by using the cladding formation varnishes and the core formation varnish.

### <Preparation of Core Formation Varnish>

Under shaded conditions, 50 parts by weight of o-cresol novolak glycidyl ether (YDCN-700-10 available from Nippon Steel & Sumikin Chemical Co. , Ltd.), 50 parts by weight of bisphenoxyethanolfluorene diglycidyl ether (OGSOL EG available from Osaka Gas Chemicals Co., Ltd.) and 1 part by weight of a photopolymerization initiator (SP170 available from Adeka Corporation) were mixed together with 50 parts by weight of ethyl lactate (available from Musashino Chemical Laboratory, Ltd.) and completely dissolved in ethyl lactate at 85°C with heating and stirring. Then, the resulting mixture was cooled to a room temperature (25°C), and then filtered by a heat and pressure filtering process with the use of a membrane filter having a pore diameter of 1.0 µm. Thus, a core formation varnish was prepared.

### <Production of FPC-Combined Optical Waveguide>

### [Formation of Under-Cladding Layer]

### (Examples 1 to 3)

The cladding formation varnishes for Examples 1 to 3 were each applied onto a back surface of a flexible printed board substrate (FPC substrate) having an overall thickness of 22 µm by means of a spin coater, and then the organic solvent was dried on a hot plate (at 130°C for 10 minutes). Then, the resulting under-cladding formation layer was exposed to light via a predetermined mask pattern (pattern width/pattern pitch (L/S) = 50 µm/200 µm) by means of a UV irradiation machine (at 200 mJ/cm² (with an I-line filter)). Thereafter, the resulting under-cladding formation layer was developed with the use of a 1 wt% sodium carbonate aqueous solution at 30°C at a pressure of 0.2 MPa for 90 seconds, then rinsed with tap water for 90 seconds, and subjected to light exposure (at 650 mJ/cm² (with an I-line filter) and then a heat treatment (at 140°C for 30 minutes). Thus, an under-cladding layer (having a thickness of 20 µm) was formed.

### (Comparative Examples 1 and 2)

The cladding formation varnishes for Comparative Examples 1 and 2 were each applied onto a back surface of a flexible printed board substrate (FPC substrate) having an overall thickness of 22 µm by means of a spin coater. In turn, the resulting under-cladding formation layer was exposed to light via a predetermined mask pattern (pattern width/pattern pitch (L/S) = 50 µm/200 µm) by means of a UV irradiation machine (at 5000 mJ/cm² (with an I-line filter)), and subjected to a post heat treatment (at 130°C for 10 minutes). Thereafter, the resulting under-cladding formation layer was developed in γ-butyrolactone (at 25°C for 3 minutes) and rinsed with water, and then dried on a hot plate (at 120°C for 10 minutes) for removal of water. Thus, an under-cladding layer (having a thickness of 20 µm) was formed.

### [Formation of Core Layer]

### (Examples 1 to 3 and Comparative Examples 1 and 2)

The core formation varnish was applied over the formed under-cladding layer by means of a spin coater, and then the organic solvent was dried on a hot plate (at 130°C for 5 minutes). Thus, a core formation layer was formed in an uncured film state. The uncured core formation layer thus formed was exposed to light via a predetermined mask pattern (pattern width/pattern pitch (L/S) = 50 µm/200 µm) by means of a UV irradiation machine (at 9000 mJ/cm² (with an I-line filter)), and then subjected to a post heat treatment (at 130°C for 10 minutes). Thereafter, the resulting core formation layer was developed in γ-butyrolactone (at 25°C for 4 minutes) and rinsed with water, and then dried on a hot plate (at 120°C for 10 minutes) for removal of water. Thus, a core layer (having a thickness of 50 µm) was formed as having the predetermined pattern.

### [Formation of Over-Cladding Layer]

### (Examples 1 to 3)

The cladding formation varnishes for Examples 1 to 3 were each applied over the formed core layer on the back surface of the flexible printed board substrate (FPC substrate) having an overall thickness of 22 µm by means of a spin coater, and then the organic solvent was dried on a hot plate (at 130°C for 30 minutes). Then, the resulting over-cladding formation layer was exposed to light via a predetermined mask pattern (pattern width/pattern pitch (L/S) = 50 µm/200 µm) by means of a UV irradiation machine (at 200 mJ/cm² (with an I-line filter)). Thereafter, the resulting over-cladding formation layer was developed with the use of a 1 wt% sodium carbonate aqueous solution at 30°C at a pressure of 0.2 MPa for 90 seconds, then rinsed with tap water for 90 seconds, and subjected to light exposure (at 650 mJ/cm² (with an I-line filter)) and then a heat treatment (at 140°C for 30 minutes). Thus, an over-cladding layer (having a thickness of 10 µm) was formed.

### (Comparative Examples 1 and 2)

The cladding formation varnishes for Comparative Examples 1 and 2 were each applied over the formed core layer by means of a spin coater, whereby an uncured over-cladding formation layer was formed. In turn, the uncured over-cladding formation layer thus formed was exposed to light by means of a UV irradiation machine (at 5000 mJ/cm² (with an I-line filter)), and subjected to a post heat treatment (at 130°C for 10 minutes). Thereafter, the resulting over-cladding formation layer was developed in γ-butyrolactone (at 25°C for 3 minutes) and rinsed with water, and then dried on a hot plate (at 120°C for 10 minutes) for removal of water. Thus, an over-cladding layer (having a thickness of 10 µm) was formed.

In this manner, the FPC-combined optical waveguides of the inventive examples and the comparative examples (each having an overall waveguide thickness of 80 µm) were each produced as including the under-cladding layer formed on the FPC substrate, the core layer formed in the predetermined pattern on the under-cladding layer, and the over-cladding layer formed over the core layer.

The optical waveguides thus produced were evaluated for physical properties based on the following criteria. The results are shown below in Tables 1 and 2.

### [Flame Resistance Test]

The optical waveguides were each evaluated for flame resistance by a VTM method by means of a device (No. 1031 HVUL UL combustion test chamber available from Toyo Seiki Seisaku-sho Ltd.) in conformity with the Flame Resistance Test Standard UL94. The evaluation was based on the following criteria.
Acceptable (○) : An optical waveguide satisfying VTM-0.
Unacceptable (x): An optical waveguide not satisfying VTM-0.

**Table 1 (parts by weight)**

| | | Example | |
|---|---|---|---|
| | 1 | 2 | 3 |
| Phosphorus-containing epoxy resin | 13.1 | 40 | 3 |
| Aliphatic modified epoxy resin | - | - | - |
| Aliphatic epoxy resin | - | - | - |
| Cyclic phosphazene compound | 8.5 | - | 9.5 |
| Carboxyl group-containing linear polymer | 30 | 15 | 30 |
| Ethylenically unsaturated group-containing polymerizable compound | 6.8 | 3.4 | 6.8 |
| Polyfunctional ethylenically unsaturated group-containing polymerizable compound | 0.98 | 0.49 | 0.98 |
| Photopolymerization initiator (a) | 1.3 | 0.65 | 1.3 |
| Photopolymerization initiator (b) | 1.3 | 0.65 | 1.3 |
| Photopolymerization initiator (c) | - | - | - |
| Flame resistance | ○ | ○ | ○ |

**Table 2 (parts by weight)**

| | Comparative Example | |
|---|---|---|
| | 1 | 2 |
| Phosphorus-containing epoxy resin | - | - |
| Aliphatic modified epoxy resin | 45.4 | 25 |
| Aliphatic epoxy resin | 11.4 | - |
| Cyclic phosphazene compound | - | - |
| Carboxyl group-containing linear polymer | - | 30 |
| Ethylenically unsaturated group-containing polymerizable compound | - | 6.8 |
| Polyfunctional ethylenically unsaturated group-containing polymerizable compound | - | 0.98 |
| Photopolymerization initiator (a) | - | - |
| Photopolymerization initiator (b) | - | - |
| Photopolymerization initiator (c) | 1 | 1 |
| Flame resistance | × | × |

As a result of the flame resistance test, the optical waveguides of the inventive examples were rated as excellent in flame resistance. In contrast, the optical waveguides of the comparative examples failed to satisfy VTM-0, and were rated as inferior in flame resistance

While specific forms of the embodiment of the present invention have been shown in the aforementioned inventive examples, the inventive examples are merely illustrative of the invention but not limitative of the invention. It is contemplated that various modifications apparent to those skilled in the art could be made within the scope of the invention.

The optical waveguide and the opto-electric hybrid board according to the embodiment of the present invention are excellent in flame resistance, and permit thickness reduction thereof. Therefore, the optical waveguide and the opto-electric hybrid board are applicable to various use purposes, e.g., to light transmission flexible printed boards and the like.

## Claims

1. An optical waveguide comprising:
a core layer; and
a cladding layer;
wherein at least one of the core layer and the cladding layer is formed from a transparent resin composition comprising a phosphorus-containing epoxy resin and a photopolymerization initiator.

2. The optical waveguide according to claim 1, wherein the optical waveguide does not include a flame resistant cover layer.

3. The optical waveguide according to claim 1 or 2, wherein the phosphorus-containing epoxy resin is an epoxy resin having a phenyl phosphate skeleton represented by the following general formula (1): 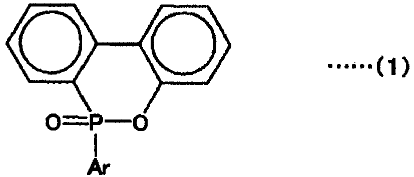 wherein Ar is an aromatic group.

4. The optical waveguide according to any one of claims 1 to 3, wherein the transparent resin composition further comprises a cyclic phosphazene compound represented by the following general formula (2): 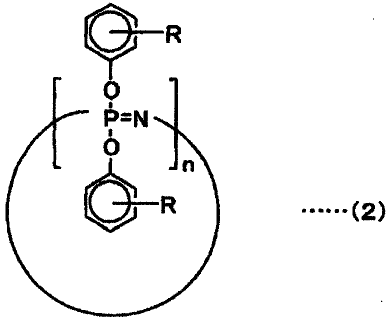 wherein Rs are each a hydrogen atom, a hydroxyl group or an organic group having a urethane (meth)acrylate structure represented by the following general formula (3), at least one of the Rs being the organic group having the urethane (meth)acrylate structure, and n is a positive number of 2 to 5, representing an average polymerization degree: 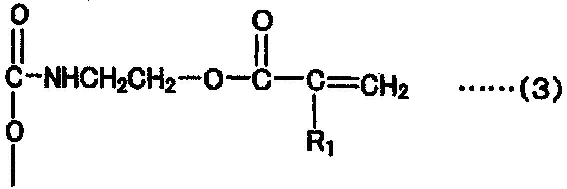 wherein R₁ is a hydrogen atom or a methyl group.

5. An opto-electric hybrid board comprising the optical waveguide according to any one of claims 1 to 4.
